(19) **Europäisches Patentamt / European Patent Office / Office européen des brevets**

(11) **EP 4 564 036 A1**

(12) # DEMANDE DE BREVET EUROPEEN

(43) Date de publication:
04.06.2025 Bulletin 2025/23

(21) Numéro de dépôt: 24214695.9

(22) Date de dépôt: 22.11.2024

(51) Classification Internationale des Brevets (IPC):
*G01R 31/392* (2019.01)    *G01R 31/367* (2019.01)

(52) Classification Coopérative des Brevets (CPC):
G01R 31/392; G01R 31/367

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: 29.11.2023 FR 2313274

(71) Demandeur: **Commissariat à l'Energie Atomique et aux Energies Alternatives**
**75015 Paris (FR)**

(72) Inventeurs:
• **DESEURE, Jonathan**
**38054 GRENOBLE CEDEX 09 (FR)**
• **BICHOT, Lauriane**
**38054 GRENOBLE CEDEX 09 (FR)**
• **MONTARU, Maxime**
**38054 GRENOBLE CEDEX 09 (FR)**

(74) Mandataire: **Brevalex**
**Tour Trinity**
**1 B Place de la Défense**
**92400 Courbevoie (FR)**

(54) **MÉTHODE ET DISPOSITIF POUR DÉTECTER UNE DÉFAILLANCE D'UNE CELLULE DE BATTERIE LITHIUM-ION**

(57) L'invention concerne une méthode (100) pour détecter une défaillance d'une cellule d'une batterie Lithium-ion. La méthode comporte, pour au moins une phase CV d'un cycle de charge CC-CV de la cellule :
- une collecte (110) de plusieurs mesures formant un signal de courant de floating,
- une dérivation (120) du signal de courant de floating,
- une décomposition en modes empiriques (130) de la dérivée du courant de floating,
- une détermination (150) d'une valeur d'incidence représentative de l'état de santé de la cellule, pour la phase CV considérée, à partir des composantes intrinsèques obtenues par la décomposition,
- une évaluation (160) d'un critère de défaillance de la cellule en fonction de la valeur d'incidence.

[Fig. 1]

EP 4 564 036 A1

## Description

### Domaine de l'invention

La présente invention appartient au domaine de la gestion des batteries de type « Lithium-Ion ». Plus particulièrement, il est proposé une méthode et un dispositif pour détecter une défaillance d'une cellule de batterie Lithium-Ion, dans le but notamment de prévenir un accident (explosion, incendie ou autre) au cours de la vie de la batterie.

### Etat de la technique

Il existe actuellement différentes méthodes de détection de défaillances des batteries au lithium.

Certaines méthodes se basent sur des mesures de propriétés électromécaniques de la batterie (vibration, ondes acoustiques, etc.). Ces mesures peuvent être utilisées pour identifier des signes précoces de défaillance, tels que des fissures, des délaminations et des défauts de fabrication.

Certaines méthodes se basent sur des mesures de propriétés thermiques de la batterie, telles que la température, la conductivité thermique et la capacité thermique. Ces mesures peuvent être utilisées pour identifier un échauffement anormal de la batterie.

Un inconvénient de ces méthodes réside dans le fait que la défaillance est détectée de façon assez tardive. Ces méthodes ne permettent donc pas toujours de prévenir de façon satisfaisante un accident lié à une défaillance de la batterie.

D'autres méthodes se basent sur des mesures des propriétés électrochimiques de la batterie, telles que la tension, le courant, la résistance ou la capacité.

Parmi ces méthodes électrochimiques, un grand nombre se basent sur des signaux de tension mesurés au niveau de la batterie. On peut citer par exemple les demandes de brevet US 2017/146608 A1 et US 2022/0381849 A1. La demande de brevet EP 3324197 A1 décrit quant à elle une méthode pour déterminer l'état de santé d'une cellule de batterie en fonction d'un rapport entre une variation de charge et une différence de courant mesurées entre deux instants d'une phase CV (phase de charge à tension constante) d'un cycle CC-CV (cycle de charge comportant une phase de charge à courant constant suivi d'une phase de charge à tension constante). La fiabilité de ces méthodes de détection d'une défaillance n'est toutefois pas toujours pleinement satisfaisante. En particulier, ces méthodes ne permettent généralement pas d'anticiper suffisamment tôt une défaillance d'une cellule de batterie.

### Exposé de l'invention

La présente invention a pour objectif de remédier à tout ou partie des inconvénients de l'art antérieur, notamment ceux exposés ci-avant.

A cet effet, et selon un premier aspect, il est proposé par la présente invention, une méthode pour détecter une défaillance d'une cellule d'une batterie Lithium-Ion. La méthode comporte, pour au moins une phase « tension constante » (phase CV) d'un cycle de charge « courant constant - tension constante » (cycle de charge CC-CV) de la cellule :

- une collecte d'une pluralité de mesures de courant effectuées au niveau de la cellule pendant ladite au moins une phase CV, ladite pluralité de mesures formant un signal de « courant de floating »,
- une dérivation du signal de courant de floating pour obtenir un signal de dérivée de courant de floating,
- une décomposition en modes empiriques du signal de dérivée de courant de floating afin d'en obtenir une représentation sous la forme d'une somme d'un signal résiduel et d'une ou plusieurs composantes intrinsèques,
- une détermination d'une valeur d'incidence représentative d'un état de santé de la cellule, pour ladite au moins une phase CV, à partir des composantes intrinsèques ainsi obtenues,
- une évaluation d'un critère de détection d'une défaillance de la cellule en fonction de la valeur d'incidence de ladite au moins une phase CV.

Dans des modes particuliers de mise en oeuvre, l'invention peut comporter en outre l'une ou plusieurs des caractéristiques suivantes, prises isolément ou selon toutes les combinaisons techniquement possibles.

Dans des modes particuliers de mise en oeuvre, la détermination de la valeur d'incidence, pour ladite au moins une phase CV, comprend :

- un calcul d'une énergie pour chaque composante intrinsèque,
- un calcul d'une énergie intrinsèque totale égale à une somme des énergies des composantes intrinsèques,
- une détermination de la valeur d'incidence en fonction de l'énergie intrinsèque totale ainsi calculée.

Dans des modes particuliers de mise en oeuvre, la détermination de la valeur d'incidence, pour ladite au moins une phase CV, comprend :

- un calcul d'une densité spectrale pour chaque composante intrinsèque,
- un calcul d'une densité spectrale intrinsèque totale égale à une somme des densités spectrales des différentes composantes intrinsèques,
- une détermination de la valeur d'incidence en fonction de la densité spectrale intrinsèque totale ainsi calculée.

Dans des modes particuliers de mise en oeuvre, pour chaque composante intrinsèque, la densité spectrale de la composante intrinsèque est calculée à partir d'une transformée de Hilbert de la composante intrinsèque.

La méthode proposée se distingue nettement des méthodes conventionnelles en ce qu'elle se base sur l'analyse de la dérivée du courant de floating pendant une phase CV d'un cycle de charge CC-CV. Rien ne suggère au premier abord que ce signal renferme des informations pertinentes pour le suivi de l'état de santé de la cellule.

La décomposition en modes empiriques est particulièrement bien adaptée à l'analyse de ce signal. Cette décomposition présente en outre l'avantage d'être relativement rapide et peu gourmande en termes de capacité de calcul.

Le suivi de l'énergie intrinsèque totale ou de la densité spectrale intrinsèque totale de la cellule permet de détecter une défaillance de façon anticipé et efficace.

Dans des modes particuliers de mise en oeuvre, la méthode comporte en outre, pour ladite au moins une phase CV, une estimation d'une fiabilité statistique de la phase CV, en fonction des composantes intrinsèques du signal de dérivée de courant de floating. La phase CV est filtrée si celle-ci est jugée non fiable.

Dans des modes particuliers de mise en oeuvre, la fiabilité statistique de la phase CV est estimée en fonction d'une entropie calculée pour une somme des composantes intrinsèques du signal de dérivée de courant de floating.

Dans des modes particuliers de mise en oeuvre, la fiabilité statistique de la phase CV est estimée en comparant l'énergie intrinsèque totale avec un seuil d'énergie prédéterminé, ou avec les énergies intrinsèques totales calculées pour tout ou partie de phases CV précédentes.

Cette étape de filtrage des phases CV jugées non fiables statistiquement permet d'écarter les phases CV présentant des valeurs d'incidence aberrantes.

Dans des modes particuliers de mise en oeuvre, l'évaluation du critère de détection d'une défaillance de la cellule comporte une comparaison de la valeur d'incidence avec un seuil d'incidence prédéterminé, pour ladite au moins une phase CV.

Dans des modes particuliers de mise en oeuvre, l'évaluation du critère de détection d'une défaillance de la cellule comporte une comparaison d'une pente d'une interpolation linéaire effectuée pour un ensemble de plusieurs valeurs d'incidence correspondant à plusieurs phases CV consécutives avec un seuil de pente prédéterminé.

Dans des modes particuliers de mise en oeuvre, l'évaluation du critère de détection d'une défaillance de la cellule comporte une comparaison de la valeur d'incidence pour ladite au moins une phase CV avec une valeur d'incidence d'une phase CV précédente.

Ces différents critères peuvent être utilisés, de façon individuelle ou en combinaison, pour détecter une défaillance de la cellule.

Dans des modes particuliers de mise en oeuvre, lorsqu'une défaillance est détectée, la méthode comporte en outre une vérification si la défaillance détectée est liée à l'environnement dans lequel la cellule a évolué.

Dans des modes particuliers de mise en oeuvre, la vérification si la défaillance détectée est liée à l'environnement comprend une comparaison, pour une période donnée comportant ladite au moins une phase CV, de valeurs d'incidence déterminées pour la cellule pendant ladite période avec des valeurs d'incidence déterminées pour au moins une autre cellule soumise au même environnement pendant ladite période.

Dans des modes particuliers de mise en oeuvre, la vérification si la défaillance détectée est liée à l'environnement comprend une comparaison, pour une période donnée comportant ladite au moins une phase CV, de mesures d'environnement effectuées pendant ladite période avec un seuil prédéterminé.

Il peut en effet être avantageux de savoir si une défaillance détectée est liée à l'environnement dans lequel la cellule a évolué. Si la défaillance est liée à l'environnement, il est possible de prendre une mesure corrective au niveau de l'environnement de la cellule, et la défaillance aura potentiellement un impact limité dans le temps. Une défaillance qui n'est pas liée à l'environnement est potentiellement plus grave puisqu'elle présage d'une défaillance intrinsèque à la cellule, comme par exemple une défaillance liée à un défaut de fabrication ou à une dégradation précoce de la cellule. Une défaillance intrinsèque à la cellule peut nécessiter une mise en sécurité de la cellule pour éviter un risque d'accident (gonflement de la cellule, risque de rupture d'un boîtier enfermant la cellule, emballement thermique, risque d'incendie ou d'explosion, etc.).

Selon un deuxième aspect, il est proposé par la présente invention, un dispositif pour détecter une défaillance d'une cellule d'une batterie Lithium-Ion. Le dispositif comporte :

- un système de gestion de batterie configuré pour fournir des mesures de courant effectuées au niveau de la cellule pendant une phase « tension constante » (phase CV) d'un cycle de charge « courant constant - tension constante » (cycle de charge CC-CV) de la cellule,
- une unité de calcul connectée au système de gestion de batterie, ladite unité de calcul étant configurée pour mettre en oeuvre une méthode selon l'un quelconque des modes de mise en oeuvre précédemment décrits.

**Présentation des figures**

L'invention sera mieux comprise à la lecture de la description suivante, donnée à titre d'exemple nullement limitatif, et faite en se référant aux figures 1 à 15 qui représentent :

[Fig. 1] une représentation schématique des principales étapes d'un exemple de mise en oeuvre de la méthode selon l'invention pour détecter une défaillance d'une cellule d'une batterie Lithium-Ion,

[Fig. 2] une représentation schématique d'un mode particulier de mise en oeuvre de l'étape de détermination d'une valeur d'incidence,

[Fig. 3] une représentation schématique d'un autre mode particulier de mise en oeuvre de l'étape de détermination d'une valeur d'incidence,

[Fig. 4] un graphique représentant le courant circulant dans une cellule de batterie Lithium-Ion au cours de quatre cycles de charge CC-CV successifs,

[Fig. 5] un graphique représentant le courant de floating circulant dans une cellule de batterie Lithium-Ion au cours d'une phase CV d'un cycle de charge CC-CV de la cellule,

[Fig. 6] un graphique représentant la dérivée du courant de floating représenté à la figure 5,

[Fig. 7] un graphique représentant une décomposition en modes empiriques de la dérivée de courant de floating représenté sur la figure 6,

[Fig. 8] une représentation schématique d'un mode particulier de mise en oeuvre de l'étape d'évaluation d'un critère de détection d'une défaillance de la cellule,

[Fig. 9] un premier exemple de valeurs d'incidence déterminées successivement pour sept phases CV,

[Fig. 10] un deuxième exemple de valeurs d'incidence déterminées successivement pour sept phases CV,

[Fig. 11] un troisième exemple de valeurs d'incidence déterminées successivement pour sept phases CV,

[Fig. 12] un quatrième exemple de valeurs d'incidence déterminées successivement pour sept phases CV,

[Fig. 13] un graphique représentant l'évolution au cours du temps de la valeur d'incidence d'une cellule de batterie, ainsi que l'évolution au cours du temps, pendant la même période, de la température subie par la cellule,

[Fig. 14] un graphique représentant un autre exemple de l'évolution au cours du temps de la valeur d'incidence d'une cellule de batterie, ainsi que l'évolution au cours du temps, pendant la même période, de la température subie par la cellule,

[Fig. 15] une représentation schématique d'un dispositif selon l'invention permettant de détecter une défaillance d'une cellule d'une batterie Lithium-Ion.

Dans ces figures, des références identiques d'une figure à une autre désignent des éléments identiques ou analogues. Pour des raisons de clarté, les éléments représentés ne sont pas nécessairement à une même échelle, sauf mention contraire.

## Description détaillée de l'invention

Comme indiqué précédemment, la présente demande propose une méthode et un dispositif pour détecter une défaillance d'une cellule d'une batterie Lithium-Ion.

Un cycle de charge d'une cellule de batterie Lithium-Ion comporte classiquement deux phases : une première phase de charge à courant constant, ou phase CC (pour « Constant Current » en anglais) et une deuxième phase de charge à tension constante, ou phase CV (pour « Constant Voltage » en anglais). On parle alors d'un cycle de charge CC-CV. Dans la présente invention, on s'intéresse au courant qui circule dans la cellule pendant la phase CV. Ce courant est généralement appelé « courant de floating ».

Bien que classiquement la première phase de charge (phase CC) s'effectue à courant constant, des schémas de charge plus élaborés peuvent exister durant cette première phase, avec une évolution du courant par exemple pour maximiser la vitesse de charge tout en restant dans le domaine de charge compatible avec l'accumulateur. La fin de la première phase de charge est alors marquée par l'atteinte d'un seuil de tension qui déclenche le basculement dans la seconde phase de charge à tension constante (phase CV). Par simplicité, on considérera ces cas particuliers de première phase de charge comme également couverts par le vocable de charge CC-CV « courant constant - tension constante » utilisé dans cette demande.

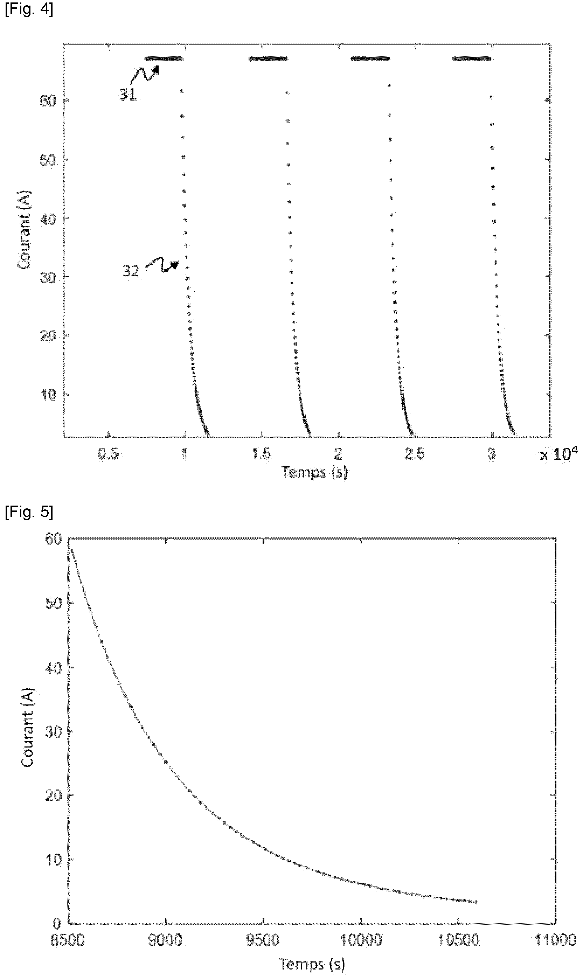

La figure 4 est un graphique représentant quatre cycles de charge CC-CV successifs d'une cellule de batterie Lithium-Ion. Le courant qui circule dans la cellule est représenté en ordonnée (en ampères) et le temps est représenté en abscisse (en secondes). Chaque cycle comporte une phase CC 31 et une phase CV 32. Tel qu'illustré sur le graphique de la figure 4, le courant qui circule dans la cellule pendant la phase CC 31 est sensiblement constant, et il présente une décroissance exponentielle pendant la phase CV 32. La figure 5 est un graphique représentant de façon plus détaillée la phase CV 32 d'un cycle de charge CC-CV de la cellule.

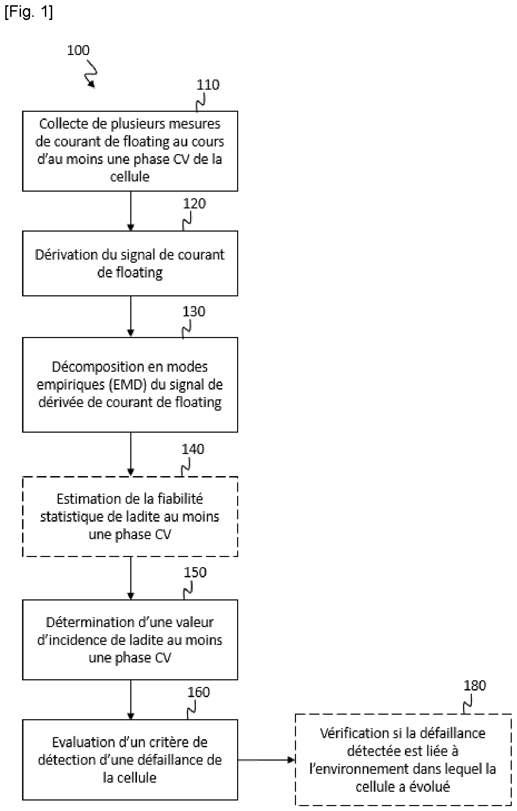

La figure 1 représente schématiquement les principales étapes d'un exemple de mise en oeuvre d'une méthode 100 selon l'invention pour détecter une défaillance d'une cellule d'une batterie Lithium-Ion.

Tel qu'illustré sur la figure 1, la méthode 100 comporte les étapes suivantes, pour au moins une phase CV d'un cycle de charge CC-CV de la cellule :

- une collecte 110 de plusieurs mesures de courant de floating pendant la phase CV,
- une dérivation 120 du courant de floating ainsi obtenu,
- une décomposition en modes empiriques 130 (EMD pour « Empirical Mode Décomposition » en anglais) de la dérivée du courant de floating,
- une détermination 150 d'une valeur d'incidence représentative d'un état de santé de la cellule à partir des composantes intrinsèques obtenues par la décomposition EMD,

- une évaluation 160 d'un critère de détection d'une défaillance de la cellule en fonction de la valeur d'incidence ainsi déterminée.

Ces étapes peuvent être mises en oeuvre pour la phase CV d'un ou plusieurs cycles de charge CC-CV subis par la cellule au cours de sa vie. Elles peuvent par exemple être mis en oeuvre à chaque nouvelle phase CV de la cellule, afin de faire un suivi systématique de l'état de santé de la cellule. Rien n'empêcherait toutefois, dans une variante, de mettre en oeuvre ces étapes uniquement pour un sous-ensemble de la totalité des cycles de charge de la cellule, par exemple à chaque fois qu'un certain nombre de cycles de charge a été effectué, ou bien avec une fréquence temporelle prédéterminée. Ces étapes peuvent également être mis en oeuvre de façon sporadique au cours de la vie de la cellule.

Les mesures de courant de floating pendant la phase CV sont par exemple effectuées par un système de gestion de batterie (BMS pour « Battery Management System » en anglais) connecté à la cellule. Les mesures sont par exemple effectuées avec une fréquence d'acquisition comprise entre une et soixante secondes, pendant une durée d'acquisition de dix à soixante minutes. Rien n'empêcherait toutefois de faire les mesures avec une fréquence d'acquisition différente, et/ou pendant une durée d'acquisition différente. Il est avantageux d'utiliser un nombre de mesures compris entre trente et cinquante par phase CV (utiliser un plus grand nombre de mesures n'implique pas nécessairement une amélioration significative de la méthode, utiliser un nombre de mesures plus faible peut en revanche limiter les performances de la méthode). L'ensemble des mesures collectées pendant l'étape de collecte 110 forment un signal de « courant de floating ». Le graphique de la figure 5 représente un exemple de signal de courant de floating obtenu à l'étape de collecte 110.

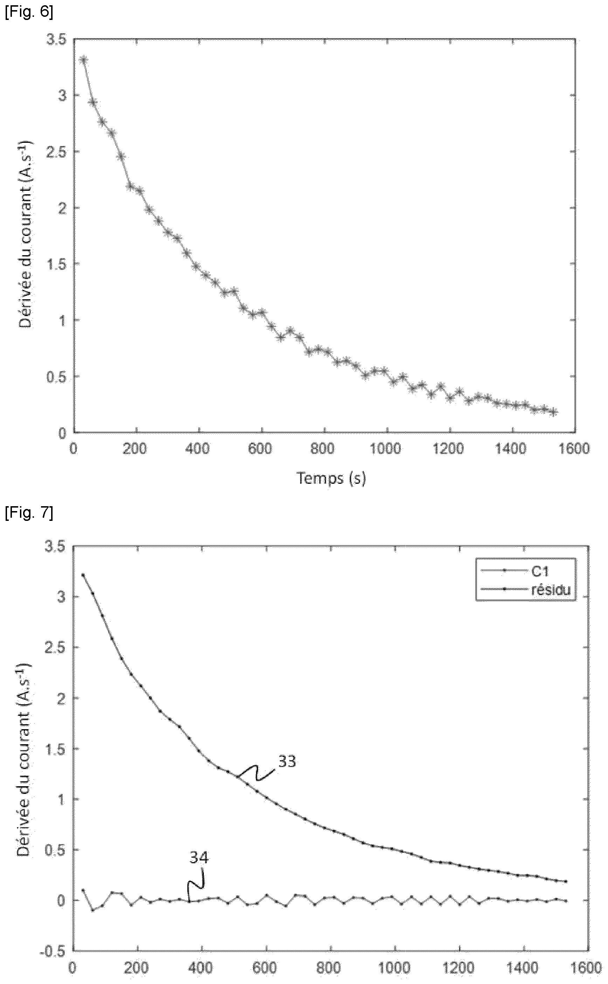

A l'étape de dérivation 120, le signal de courant de floating obtenu à l'étape 110 est dérivé pour obtenir un signal de dérivée de courant de floating. Le graphique de la figure 6 représente un exemple de signal de dérivée de courant de floating obtenu à l'étape de dérivation 120 (il s'agit de la dérivée du signal de courant de floating représenté sur le graphique de la figure 5).

A l'étape 130, le signal de dérivée de courant de floating est décomposé selon une décomposition en modes empiriques. Il convient de noter que le signal de courant de floating est généralement trop « lisse » et qu'il permet difficilement une décomposition en modes empiriques, c'est la raison pour laquelle on s'intéresse à sa dérivée, même si rien ne pouvait laisser présager au premier abord que ce signal de dérivée de courant de floating pouvait contenir des informations pertinentes sur l'état de santé de la cellule.

La décomposition en modes empiriques consiste à décomposer un signal sous la forme d'une somme de fonctions, de façon similaire à ce que fait la décomposition en série de Fourier ou la décomposition en ondelettes.

Une des particularités de la décomposition en modes empiriques est que la base de fonctions en lesquelles le signal est décomposé n'est pas connue a priori, mais elle est construite de façon adaptative en fonction des propriétés du signal.

La décomposition en modes empiriques correspond à la première partie de la transformée de Hilbert-Huang (HHT pour « Hilbert-Huang Transform » en anglais). La décomposition en modes empiriques consiste à décomposer un signal sous la forme d'une somme d'un signal résiduel et de fonctions de mode intrinsèque (IMF pour « Intrinsic Mode Function » en anglais). Dans la présente demande, ces fonctions de mode intrinsèque sont également appelées « composantes intrinsèques ».

Comme indiqué précédemment, les composantes intrinsèques ne sont pas définies analytiquement. Elles sont plutôt déterminées de façon adaptative en fonction des propriétés du signal.

Une composante intrinsèque (IMF) résultant d'une décomposition en modes empiriques (EMD) doit satisfaire aux exigences suivantes :

- le nombre d'extrema (c'est-à-dire la somme du nombre des maxima locaux et du nombre des minima locaux) et le nombre de passages par zéro de la composante intrinsèque doivent être égaux ou différer au maximum de un ;
- en tout point de la composante intrinsèque, la valeur moyenne de l'enveloppe définie par les maxima locaux et de l'enveloppe définie par les minima locaux est nulle.

Un signal s(t) décomposé par EMD peut alors s'écrire sous la forme :

$$s(t) = r(t) + \sum_{i=1}^{N} c_i(t)$$

Dans cette expression, r(t) correspond au signal résiduel, $N$ est le nombre de composantes intrinsèques de la décomposition EMD, et $c_i(t)$ est la composante intrinsèque d'indice i. Chaque composante intrinsèque $c_i$ successive contient des oscillations de fréquence inférieure à celle de la précédente. Le signal résiduel correspond à une tendance générale du signal s(t).

La décomposition en modes empiriques comporte une succession de processus de tamisage (« sifting process » en anglais). Le premier processus de tamisage prend en entrée le signal s(t) directement. Le processus de tamisage correspond à identifier tous les extrema locaux du signal d'entrée, et à relier les maxima locaux, respectivement les minima locaux, par une interpolation par splines cubiques, afin d'obtenir une enveloppe supérieure, respectivement une enveloppe inférieure. Une moyenne entre l'enveloppe supérieure et l'enveloppe inférieure peut alors être calculée et soustraite au signal d'entrée. Si le signal intermédiaire obtenu (soustraction du signal d'entrée avec la moyenne des enveloppes supérieure et inférieure) n'est pas une composante intrinsèque, le processus de tamisage est réitéré sur le signal intermédiaire (qui devient donc le signal d'entrée d'un nouveau processus de tamisage) jusqu'à obtenir une composante intrinsèque. Les processus de tamisage sont répétés jusqu'à obtenir la dernière composante intrinsèque, c'est-à-dire par exemple jusqu'à ce que le signal intermédiaire devienne monotone ou qu'il ne comporte plus qu'un seul extremum local. Le signal restant correspond alors au signal résiduel r(t).

Un critère d'arrêt peut être défini pour le processus de tamisage. Par exemple le critère d'arrêt est satisfait si l'écart-type entre les résultats de deux processus de tamisage successifs est inférieur ou égal à un seuil d'arrêt prédéterminé. Le seuil d'arrêt peut typiquement être compris entre 0.2 et 0.3.

Le document « The empirical mode décomposition and the Hilbert spectrum for non-linear and non-stationary time series analysis », Norden E. Huang et al., Proc. R. Soc. Lond. A (1998) 454, p. 903-995, décrit de façon détaillée la décomposition en modes empiriques, notamment dans ses sections 4 et 5.

Des algorithmes de décomposition en modes empiriques sont disponibles dans des bibliothèques de programmation, par exemple en langage MATLAB ou Python.

Le graphique de la figure 7 représente un exemple de décomposition en modes empiriques du signal de dérivée de courant de floating représenté sur la figure 6. Dans l'exemple considéré et illustré à la figure 7, la décomposition en modes empiriques a donné une seule composante intrinsèque 34 ($c_1$) et un signal résiduel 33. Il convient de noter que, dans d'autres exemples, un nombre plus important de composantes intrinsèques peut être obtenu. Le nombre de composantes intrinsèques reste toutefois généralement inférieur à cinq. Il est avantageux de paramétrer le seuil d'arrêt à un niveau relativement bas, de l'ordre de 0.2, pour extraire un maximum d'information du signal de dérivée de courant de floating. Utiliser un seuil d'arrêt plus faible impose des temps de calcul particulièrement importants.

Les composantes intrinsèques obtenues à l'étape 130 sont alors utilisées à l'étape 150 pour déterminer une valeur d'incidence représentative de l'état de santé de la cellule pour la phase CV considérée.

Différentes méthodes peuvent être envisagées pour déterminer la valeur d'incidence associée à la phase CV considérée.

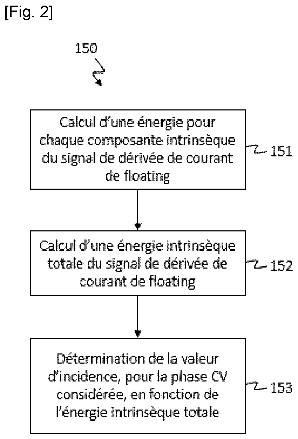

Selon un premier exemple, et tel qu'illustré sur la figure 2, la détermination 150 de la valeur d'incidence peut comporter :

- un calcul 151 d'une énergie pour chaque composante intrinsèque,

- un calcul 152 d'une énergie intrinsèque totale égale à la somme des énergies des composantes intrinsèques, et

- une détermination 153 de la valeur d'incidence en fonction de l'énergie intrinsèque totale ainsi calculée.

L'énergie $E_i$ d'une composante intrinsèque $c_i$ correspond par exemple à l'intégrale du carré de l'amplitude de la composante intrinsèque $c_i$ sur la durée d'acquisition de la phase CV considérée :

$$E_i = \int |c_i(t)|^2 dt$$

L'énergie intrinsèque totale E de la phase CV considérée peut alors s'écrire sous la forme :

$$E = \sum_{i=1}^{N} E_i$$

Il convient de noter que rien n'empêcherait, dans une variante, de calculer l'énergie intrinsèque totale E en sommant les énergies d'un sous-ensemble seulement des composantes intrinsèques obtenues par la décomposition EMD (par exemple en considérant seulement un nombre maximum prédéfini des premières composantes intrinsèques obtenues par la décomposition EMD).

La valeur d'incidence de la phase CV considérée peut alors correspondre à l'énergie intrinsèque totale de la phase CV, ou à une valeur moyenne de l'énergie intrinsèque totale pour tout ou partie des énergies intrinsèques totales calculées pour des phases CV précédentes.

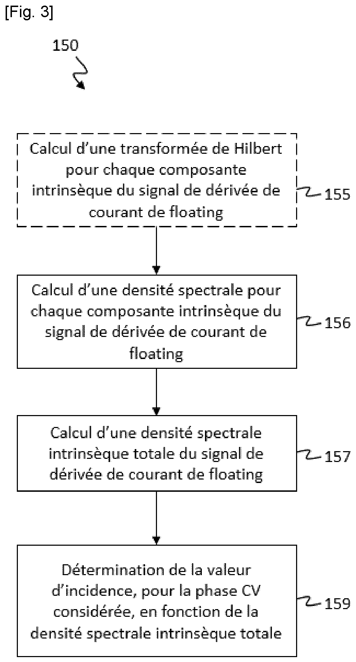

Selon un deuxième exemple, et tel qu'illustré sur la figure 3, la détermination 150 de la valeur d'incidence peut comporter :

- un calcul 156 d'une densité spectrale pour chaque composante intrinsèque,

- un calcul 157 d'une densité spectrale intrinsèque totale égale à la somme des densités spectrales des composantes intrinsèques (ou éventuellement égale à la somme des densités spectrales des composantes intrinsèques d'un sous-ensemble seulement des composantes intrinsèques), et

- une détermination 159 de la valeur d'incidence en fonction de la densité spectrale intrinsèque totale ainsi calculée.

Par exemple, la valeur d'incidence de la phase CV considérée peut correspondre à l'aire de la densité spectrale intrinsèque totale de la phase CV, ou à une valeur moyenne de l'aire de la densité spectrale intrinsèque totale pour tout ou partie des énergies intrinsèques totales calculées pour des phases CV précédentes. La valeur d'incidence pourrait aussi correspondre à un ensemble d'échantillons de la densité spectrale intrinsèque totale.

Rien n'empêcherait toutefois de déterminer la valeur d'incidence d'une phase CV en combinant l'énergie intrinsèque totale et la densité spectrale intrinsèque totale. Par exemple, la valeur d'incidence peut correspondre à un couple de valeurs comportant l'énergie intrinsèque totale et l'aire (ou un ensemble d'échantillons) de la densité spectrale intrinsèque totale de la phase CV considérée.

Les densités spectrales des différentes composantes intrinsèques peuvent notamment être calculées par la méthode de Welch. Rien n'empêcherait toutefois d'utiliser d'autres méthodes d'estimation de densité spectrale, comme par exemple les méthodes de Bartlett ou de Blackman-Tukey.

La densité spectrale de chaque composante intrinsèque peut optionnellement être calculée à partir d'une transformée de Hilbert de la composante intrinsèque. Dans ce but, et tel qu'illustré sur la figure 3, l'étape de détermination 150 de la valeur d'incidence comporte une étape supplémentaire de calcul 155 d'une transformée de Hilbert de chaque composante intrinsèque du signal de dérivée de courant de floating, préalablement à l'étape de calcul 156 des densités spectrales des composantes intrinsèques.

La transformation de Hilbert permet d'étendre un signal réel dans le domaine complexe. Le signal transformé présente alors des réponses d'amplitude nulle aux fréquences nulles. Cela permet d'éviter des artéfacts lors de l'exploitation des informations contenues dans le signal traité. La transformation de Hilbert permet ainsi d'optimiser le calcul de densité spectrale.

Des algorithmes permettant ces calculs de transformation de Hilbert et d'estimation de densité spectrale sont disponibles dans des bibliothèques de programmation, par exemple en MATLAB ou en Python.

Tel qu'illustré sur la figure 1, la méthode 100 selon l'invention peut également comporter une étape optionnelle d'estimation 140 de fiabilité statistique de la phase CV considérée, et un filtrage de la phase CV si celle-ci est jugée non fiable.

Ce filtrage d'une phase CV jugée non fiable permet d'éviter de prendre en compte des valeurs aberrantes dans l'analyse de l'état de santé de la cellule.

La fiabilité statistique d'une phase CV est estimée en fonction des composantes intrinsèques du signal de dérivée de courant de floating obtenues pour la phase CV.

Selon un premier exemple, la fiabilité statistique de la phase CV est estimée en fonction d'une entropie calculée pour la somme des composantes intrinsèques du signal de dérivée de courant de floating (par exemple pour la somme de l'ensemble des composantes intrinsèques obtenues par la décomposition EMD, ou pour la somme d'un nombre maximum prédéfini des premières composantes intrinsèques obtenues par la décomposition EMD). Différentes méthodes de calcul d'entropie peuvent être envisagés, comme par exemple un calcul d'entropie de Shannon, ou un calcul d'entropie de Kolmogorov. Par exemple, les phases CV pour lesquelles l'entropie calculée est trop faible (inférieure à un seuil d'entropie prédéterminé) sont filtrées. Un seuil d'entropie de Shannon compris entre 0.25 et 0.5 peut notamment être envisagé.

Selon un deuxième exemple, la fiabilité statistique de la phase CV est estimée en comparant l'énergie intrinsèque totale calculée pour la phase CV avec un seuil d'énergie prédéterminé. Par exemple, les phases CV qui présentent une valeur d'énergie intrinsèque totale aberrante (supérieure au seuil d'énergie) sont filtrées.

Selon encore un autre exemple, la fiabilité statistique de la phase CV est estimé en comparant l'énergie intrinsèque totale calculée pour la phase CV avec les énergies intrinsèques totales calculées pour tout ou partie de phases CV précédentes (par exemple les énergies intrinsèques totales peuvent être comparées entre elles, ou bien l'énergie intrinsèque totale de la phase CV courante peut être comparée à une valeur moyenne d'énergies intrinsèques totales de phases CV précédentes). Différents tests statistiques peuvent être envisagés dans ce but (test de Pierce, test de Pierson, etc.).

Différents critères peuvent être utilisés, de façon individuelle ou en combinaison, pour détecter une défaillance de la cellule à partir de la valeur d'incidence déterminée pour une ou plusieurs phases CV.

Selon un premier exemple, il est envisageable de comparer la valeur d'incidence avec un seuil d'incidence prédéterminé, pour une ou plusieurs phases CV. Si la valeur d'incidence (par exemple l'énergie intrinsèque totale, ou l'aire de la densité spectrale intrinsèque totale) est supérieure au seuil d'incidence, alors une alerte peut être levée. Une défaillance peut être détectée lorsqu'un certain nombre d'alertes est atteint.

Selon un deuxième exemple, pour chaque nouvelle phase CV considérée il est envisageable d'effectuer une interpolation linéaire sur les valeurs d'incidence déterminées respectivement pour la nouvelle phase CV et pour chacun d'un certain nombre de phases CV précédentes, et de comparer la pente de l'interpolation linéaire avec un seuil de pente prédéterminé. Si la pente est supérieure au seuil de pente (par exemple si la pente est strictement positive), alors une alerte peut être levée. Une défaillance peut être détectée lorsqu'un certain nombre d'alertes est atteint.

Selon un troisième exemple, il est envisageable de comparer la valeur d'incidence d'une phase CV avec une valeur d'incidence d'une phase CV précédente. Par exemple, on peut vérifier si, pour un ensemble de plusieurs valeurs d'incidence correspondant à plusieurs phases CV précédentes, la valeur d'incidence de la phase CV la plus récente est supérieure ou égale à la valeur d'incidence de la phase CV la plus ancienne.

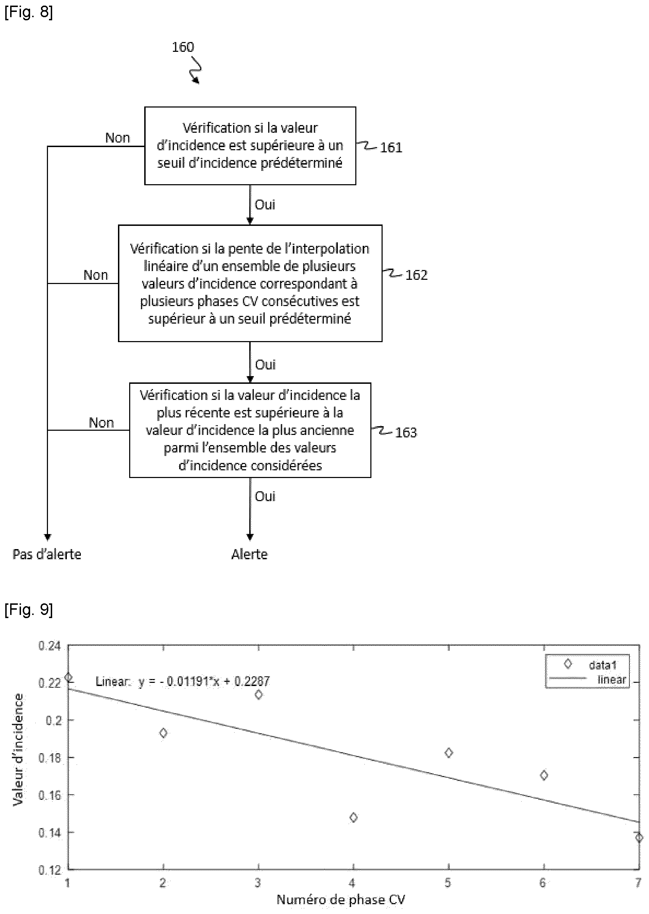

Les figures 8 à 12 illustrent, à titre d'exemple nullement limitatif, comment ces différents critères peuvent être combinés pour détecter une défaillance de la cellule. Dans l'exemple considéré, et tel qu'illustré à la figure 8, l'étape d'évaluation 160 du critère de détection d'une défaillance de la cellule comporte dans un premier temps une vérification 161 si la valeur d'incidence est supérieure à un seuil d'incidence. Si c'est le cas, alors on procède à une vérification 162 si la pente de l'interpolation linéaire des valeurs d'incidence déterminées pour les sept dernières phases CV considérées est strictement positive. Si c'est le cas, alors on procède à une vérification 163 si, parmi les sept dernières phases CV considérées, la valeur d'incidence la plus récente est strictement supérieure à la valeur d'incidence la plus ancienne. Si c'est le cas, alors une alerte est levée. Dès que l'une au moins des conditions vérifiées aux étapes 161 à 163 n'est pas satisfaite, aucune alerte n'est levée. Lorsque trois alertes sont levées pour trois phases CV considérées consécutivement, alors une défaillance est détectée.

Dans l'exemple considéré et illustré aux figures 9 à 12, une valeur d'incidence pour une phase CV correspond à une valeur moyenne glissante des énergies intrinsèques totales calculées pour les vingt dernières phases CV considérées (y compris la phase CV courante). Le seuil d'incidence est fixé à 0.15 $A^2s^{-1}$.

Il est à noter que de nombreuses autres variantes seraient possibles. Il serait par exemple envisageable de considérer que la valeur d'incidence d'une phase CV correspond à l'énergie intrinsèque totale calculée pour ladite phase CV (sans utiliser de moyenne glissante), et de faire l'interpolation linéaire sur un plus grand nombre de valeurs intrinsèques (par exemple cinquante). Il serait aussi envisageable d'utiliser l'aire de la densité spectrale intrinsèque totale comme valeur d'incidence, au lieu de l'énergie intrinsèque totale. Aussi, d'autres valeurs pourraient être envisagées pour le seuil d'incidence, le seuil de pente, le nombre de valeurs à considérer pour l'interpolation linéaire, le nombre de valeurs à considérer pour la moyenne glissante, le nombre d'alertes à lever pour déclencher la détection d'une défaillance, etc. Ces choix particuliers pour la mise en oeuvre de l'étape d'évaluation 160 du critère de détection d'une défaillance de la cellule ne sont que des variantes de l'invention.

Dans l'exemple illustré à la figure 9, la valeur d'incidence courante (valeur d'incidence d'indice sept) est inférieure au seuil d'incidence, et la pente de l'interpolation linéaire des sept dernières valeurs d'incidence est négative (autrement dit, les conditions des vérifications 161 et 162 ne sont pas satisfaites). Par conséquent aucune alerte n'est levée. Bien que les valeurs d'incidence précédentes d'indice un, deux, trois, cinq et six étaient supérieures au seuil d'incidence, aucune alerte n'avait été levée non plus car la pente de l'interpolation linéaire des sept dernières valeurs d'incidence était également négative à ces instants.

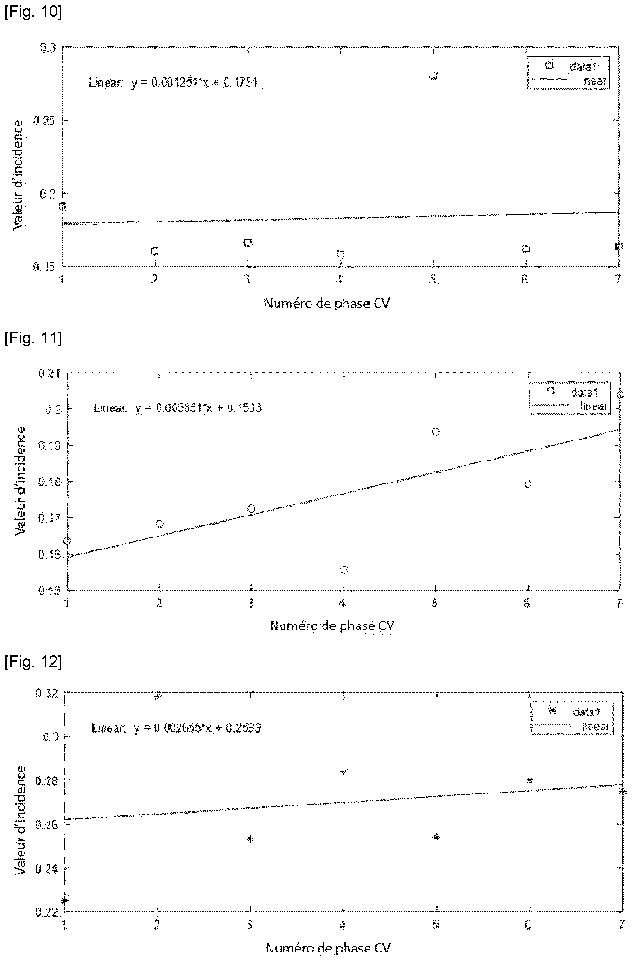

Dans l'exemple illustré à la figure 10, la valeur d'incidence courante (valeur d'incidence d'indice sept) est supérieure au seuil d'incidence, et la pente de l'interpolation linéaire des sept dernières valeurs d'incidence est strictement positive (les conditions des vérifications 161 et 162 sont donc satisfaites). Toutefois, aucune alerte n'est levée car la valeur d'incidence courante est inférieure à la valeur d'incidence d'indice un (la condition de la vérification 163 n'est donc pas satisfaite).

Dans les exemples illustrés aux figures 11 et 12, la valeur d'incidence courante (valeur d'incidence d'indice sept) est supérieure au seuil d'incidence, la pente de l'interpolation linéaire des sept dernières valeurs d'incidence est strictement positive, et la valeur d'incidence courante est supérieure à la valeur d'incidence d'indice un (les conditions des vérifications 161 à 163 sont donc toutes satisfaites et une alerte est levée. Lorsque trois alertes sont levées pour trois phases CV consécutives, alors une défaillance est détectée.

Il peut être avantageux de savoir si une défaillance détectée est liée à l'environnement dans lequel la cellule a évolué. Si la défaillance est liée à l'environnement, il est possible de prendre une mesure corrective au niveau de l'environnement de la cellule, et la défaillance aura potentiellement un impact limité dans le temps. Une défaillance qui n'est pas liée à l'environnement est potentiellement plus grave puisqu'elle présage d'une défaillance intrinsèque à la cellule, comme par exemple une défaillance liée à un défaut de fabrication ou à une dégradation précoce de la cellule. Une défaillance intrinsèque à la cellule peut nécessiter une mise en sécurité de la cellule pour éviter un risque d'accident (gonflement de la cellule, risque de rupture d'un boîtier enfermant la cellule, emballement thermique, risque d'incendie ou d'explosion, etc.).

Dans ce but, et tel qu'illustré sur la figure 1, la méthode 100 peut comporter une étape optionnelle de vérification 180 si une défaillance détectée est liée à l'environnement dans lequel la cellule a évolué.

Cette vérification 180 peut notamment comprendre une comparaison, pour une période donnée, des valeurs d'incidence mémorisées pour la cellule pendant ladite période avec des valeurs d'incidence déterminées et mémorisées pour au moins une autre cellule soumise au même environnement pendant ladite période. Si les valeurs d'incidence observées pour une ou plusieurs autres cellules soumises au même environnement mettent en évidence une évolution anormale similaire pendant une période donnée, alors il est fortement probable que ce comportement anormal soit lié à l'environnement (par exemple à cause d'une augmentation exceptionnelle de la température subie par les différentes cellules pendant cette période).

Dans une variante, la vérification 180 peut comprendre une comparaison, pour une période donnée, de mesures d'environnement effectuées et mémorisées pendant ladite période avec un seuil prédéterminé. Il peut s'agir par exemple de mesures de la température subie par la cellule.

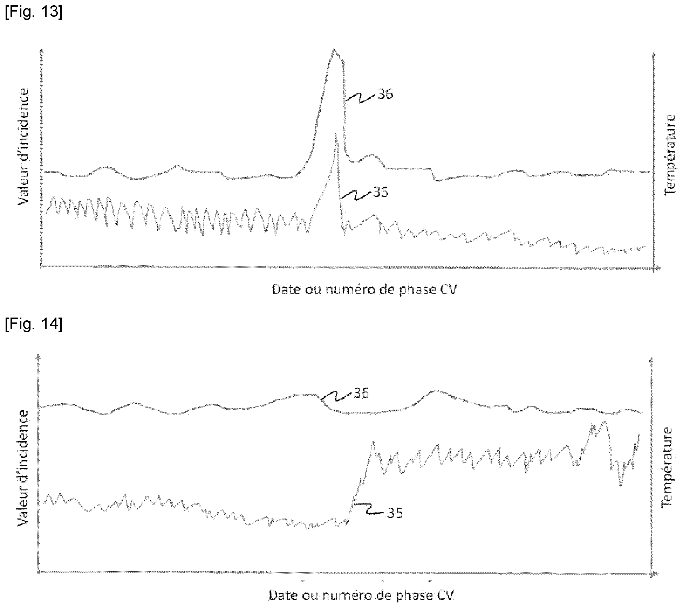

A titre d'exemple, les figures 13 et 14 illustrent l'évolution au cours du temps de la valeur d'incidence d'une cellule de batterie (courbe 35) ainsi que l'évolution au cours du temps, pendant la même période, de la température subie par la cellule (courbe 36).

Dans l'exemple illustré à la figure 13, la défaillance mise en évidence par le pic de valeur d'incidence est très probablement liée à l'environnement car un pic similaire est observé au même moment pour la température subie par la cellule.

En revanche, dans l'exemple illustré à la figure 14, il n'y a pas de corrélation particulière entre l'évolution de la valeur d'incidence et l'évolution de la température. La défaillance mise en évidence par l'augmentation brutale des valeurs d'incidence ne semble donc pas liée à l'environnement.

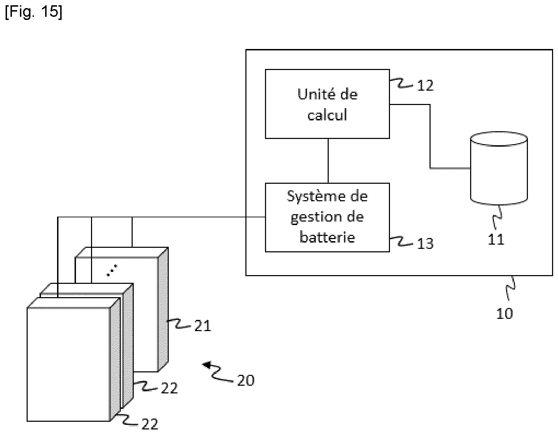

La figure 15 représente schématiquement un dispositif 10 pour détecter une défaillance d'une cellule 21 d'une batterie 22 Lithium-Ion. Le dispositif 10 comporte notamment une mémoire 11, un système de gestion 13 de batterie et une unité de calcul 12 connectée à la mémoire 11 et au système de gestion 13 de batterie.

Le système de gestion de batterie est configuré pour fournir des mesures de courant effectuées au niveau de la cellule 21 pendant une phase CV d'un cycle de charge CC-CV.

L'unité de calcul 12 est configurée pour mettre en oeuvre la méthode 100 selon l'un quelconque des modes de mise en oeuvre décrits ci-avant.

Le dispositif 10 peut en outre comporter un capteur configuré pour mesurer l'environnement (par exemple un capteur de température).

Le système de gestion 13 de batterie peut également être configuré pour fournir des mesures de courant de floating d'une ou plusieurs autres cellules 22 soumises à un même environnement que la cellule 21.

La description ci-avant illustre clairement que, par ses différentes caractéristiques et leurs avantages, la présente invention atteint les objectifs fixés. En particulier, le suivi de l'énergie intrinsèque totale ou de la densité spectrale intrinsèque totale de la cellule permet efficacement de détecter une défaillance de façon anticipée. Dans des tests réalisés en laboratoire, il a été possible de détecter plusieurs jours à l'avance, voire même plusieurs semaines à l'avance, la défaillance d'une cellule de batterie (la défaillance est détectée de façon anticipée avant un gonflement de la cellule qui conduit généralement à une rupture du boîtier de la cellule).

## Revendications

1. Méthode (100) pour détecter une défaillance d'une cellule (21) d'une batterie (20) Lithium-Ion, la méthode (100) comportant, pour au moins une phase « tension constante », ou phase CV (32), d'un cycle de charge « courant constant - tension constante », ou cycle de charge CC-CV, de la cellule :

- une collecte (110) d'une pluralité de mesures de courant effectuées au niveau de la cellule (21) pendant ladite au moins une phase CV, ladite pluralité de mesures formant un signal de « courant de floating »,
- une dérivation (120) du signal de courant de floating pour obtenir un signal de dérivée de courant de floating,
- une décomposition en modes empiriques (130) du signal de dérivée de courant de floating afin d'en obtenir une représentation sous la forme d'une somme d'un signal résiduel et d'une ou plusieurs composantes intrinsèques,
- une détermination (150) d'une valeur d'incidence représentative d'un état de santé de la cellule (21), pour ladite au moins une phase CV, à partir des composantes intrinsèques ainsi obtenues,
- une évaluation (160) d'un critère de détection d'une défaillance de la cellule (21) en fonction de la valeur d'incidence de ladite au moins une phase CV.

2. Méthode (100) selon la revendication 1, dans laquelle la détermination (150) de la valeur d'incidence, pour ladite au moins une phase CV, comprend :

- un calcul (151) d'une énergie pour chaque composante intrinsèque,
- un calcul (152) d'une énergie intrinsèque totale égale à une somme des énergies des composantes intrinsèques,
- une détermination (153) de la valeur d'incidence en fonction de l'énergie intrinsèque totale ainsi calculée.

3. Méthode (100) selon l'une quelconque des revendications 1 à 2, dans laquelle la détermination (150) de la valeur d'incidence, pour ladite au moins une phase CV, comprend :

- un calcul (156) d'une densité spectrale pour chaque composante intrinsèque,
- un calcul (157) d'une densité spectrale intrinsèque totale égale à une somme des densités spectrales des différentes composantes intrinsèques,
- une détermination (159) de la valeur d'incidence en fonction de la densité spectrale intrinsèque totale ainsi calculée.

4. Méthode (100) selon la revendication 3, dans laquelle, pour chaque composante intrinsèque, la densité spectrale de la composante intrinsèque est calculée à partir d'une transformée de Hilbert de la composante intrinsèque.

**5.** Méthode (100) selon l'une quelconque des revendications 1 à 4, comportant en outre, pour ladite au moins une phase CV, une estimation (140) d'une fiabilité statistique de la phase CV, en fonction des composantes intrinsèques du signal de dérivée de courant de floating, et un filtrage de la phase CV si celle-ci est jugée non fiable.

**6.** Méthode (100) selon la revendication 5, dans laquelle la fiabilité statistique de la phase CV est estimée en fonction d'une entropie calculée pour une somme des composantes intrinsèques du signal de dérivée de courant de floating.

**7.** Méthode (100) selon la revendication 5, en combinaison avec la revendication 2, dans laquelle la fiabilité statistique de la phase CV est estimée en comparant l'énergie intrinsèque totale avec un seuil d'énergie prédéterminé, ou avec les énergies intrinsèques totales calculées pour tout ou partie de phases CV précédentes.

**8.** Méthode (100) selon l'une quelconque des revendications 1 à 7, dans laquelle l'évaluation (160) du critère de détection d'une défaillance de la cellule (21) comporte une comparaison de la valeur d'incidence avec un seuil d'incidence prédéterminé, pour ladite au moins une phase CV.

**9.** Méthode (100) selon l'une quelconque des revendications 1 à 8, dans laquelle l'évaluation (160) du critère de détection d'une défaillance de la cellule (21) comporte une comparaison d'une pente d'une interpolation linéaire effectuée pour un ensemble de plusieurs valeurs d'incidence correspondant à plusieurs phases CV consécutives avec un seuil de pente prédéterminé.

**10.** Méthode (100) selon l'une quelconque des revendications 1 à 9, dans laquelle l'évaluation (160) du critère de détection d'une défaillance de la cellule (21) comporte une comparaison de la valeur d'incidence pour ladite au moins une phase CV avec une valeur d'incidence d'une phase CV précédente.

**11.** Méthode (100) selon l'une quelconque des revendications 1 à 10 dans laquelle, lorsqu'une défaillance est détectée, la méthode comporte en outre une vérification (180) si la défaillance détectée est liée à l'environnement dans lequel la cellule (21) a évolué.

**12.** Méthode (100) selon la revendication 11, dans laquelle la vérification (180) si la défaillance détectée est liée à l'environnement comprend une comparaison, pour une période donnée comportant ladite au moins une phase CV, de valeurs d'incidence déterminées pour la cellule (21) pendant ladite période avec des valeurs d'incidence déterminées pour au moins une autre cellule (22) soumise au même environnement pendant ladite période.

**13.** Méthode (100) selon l'une quelconque des revendications 11 à 12, dans laquelle la vérification (180) si la défaillance détectée est liée à l'environnement comprend une comparaison, pour une période donnée comportant ladite au moins une phase CV, de mesures d'environnement effectuées pendant ladite période avec un seuil prédéterminé.

**14.** Dispositif (10) pour détecter une défaillance d'une cellule (21) d'une batterie (20) Lithium-Ion, ledit dispositif (10) comportant :

- un système de gestion (13) de batterie configuré pour fournir des mesures de courant effectuées au niveau de la cellule (21) pendant une phase « tension constante », ou phase CV, d'un cycle de charge « courant constant - tension constante », ou cycle de charge CC-CV, de la cellule (21),
- une unité de calcul (12) connectée au système de gestion (13) de batterie, ladite unité de calcul (12) étant configurée pour mettre en oeuvre une méthode selon l'une quelconque des revendications 1 à 13.

[Fig. 1]

100

110

Collecte de plusieurs mesures de courant de floating au cours d'au moins une phase CV de la cellule

120

Dérivation du signal de courant de floating

130

Décomposition en modes empiriques (EMD) du signal de dérivée de courant de floating

140

Estimation de la fiabilité statistique de ladite au moins une phase CV

150

Détermination d'une valeur d'incidence de ladite au moins une phase CV

160

Evaluation d'un critère de détection d'une défaillance de la cellule

180

Vérification si la défaillance détectée est liée à l'environnement dans lequel la cellule a évolué

[Fig. 2]

[Fig. 3]

150

Calcul d'une transformée de Hilbert pour chaque composante intrinsèque du signal de dérivée de courant de floating — 155

Calcul d'une densité spectrale pour chaque composante intrinsèque du signal de dérivée de courant de floating — 156

Calcul d'une densité spectrale intrinsèque totale du signal de dérivée de courant de floating — 157

Détermination de la valeur d'incidence, pour la phase CV considérée, en fonction de la densité spectrale intrinsèque totale — 159

[Fig. 4]

[Fig. 5]

[Fig. 6]

[Fig. 7]

[Fig. 8]

160

Vérification si la valeur
d'incidence est supérieure à un ⟿ 161
seuil d'incidence prédéterminé

Non ⟵

Oui ↓

Vérification si la pente de l'interpolation
linéaire d'un ensemble de plusieurs
valeurs d'incidence correspondant à ⟿ 162
plusieurs phases CV consécutives est
supérieur à un seuil prédéterminé

Non ⟵

Oui ↓

Vérification si la valeur d'incidence la
plus récente est supérieure à la
valeur d'incidence la plus ancienne ⟿ 163
parmi l'ensemble des valeurs
d'incidence considérées

Non ⟵

Oui ↓

Pas d'alerte                    Alerte

[Fig. 9]

Linear: y = - 0.01191*x + 0.2287

◇ data1
— linear

Valeur d'incidence

Numéro de phase CV

[Fig. 10]

[Fig. 11]

[Fig. 12]

[Fig. 13]

Date ou numéro de phase CV

[Fig. 14]

Date ou numéro de phase CV

[Fig. 15]

Europäisches
Patentamt

European
Patent Office

Office européen
des brevets

# RAPPORT DE RECHERCHE EUROPEENNE

Numéro de la demande

EP 24 21 4695

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | CN 115 859 584 A (SHENZHEN INST OF ADV TECH CAS) 28 mars 2023 (2023-03-28) * page 8; revendication 1 * ----- | 1-14 | INV. G01R31/392 G01R31/367 |
| A | CN 113 156 325 A (UNIV JILIN) 23 juillet 2021 (2021-07-23) * le document en entier * ----- | 1-14 | |
| A | CN 116 840 697 A (NANJING INST TECH) 3 octobre 2023 (2023-10-03) * le document en entier * ----- | 1-14 | |
| A | US 2014/372054 A1 (WANG SHUOQIN [US] ET AL) 18 décembre 2014 (2014-12-18) * alinéa [0102]; figure 1 * ----- | 1-14 | |

**DOMAINES TECHNIQUES RECHERCHES (IPC)**

G01R

Le présent rapport a été établi pour toutes les revendications

| Lieu de la recherche | Date d'achèvement de la recherche | Examinateur |
|---|---|---|
| La Haye | 26 mars 2025 | Reeb, Bertrand |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.............................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 24 21 4695

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-03-2025

| Document brevet cité au rapport de recherche | | Date de publication | Membre(s) de la famille de brevet(s) | | Date de publication |
|---|---|---|---|---|---|
| CN 115859584 | A | 28-03-2023 | CN | 115859584 A | 28-03-2023 |
| | | | WO | 2024109760 A1 | 30-05-2024 |
| CN 113156325 | A | 23-07-2021 | AUCUN | | |
| CN 116840697 | A | 03-10-2023 | AUCUN | | |
| US 2014372054 | A1 | 18-12-2014 | AUCUN | | |

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2017146608 A1
- US 20220381849 A1
- EP 3324197 A1

**Littérature non-brevet citée dans la description**

- **NORDEN E. HUANG et al.** The empirical mode décomposition and the Hilbert spectrum for non-linear and non-stationary time series analysis. *Proc. R. Soc. Lond. A*, 1998, vol. 454, 903-995